Europäisches Patentamt

(19) European Patent Office

Office européen des brevets

(11) Publication number: **0 265 212**
**A1**

(12) **EUROPEAN PATENT APPLICATION**

(21) Application number: **87309226.6**

(22) Date of filing: **19.10.87**

(51) Int. Cl.⁴: **H 01 B 5/14**
**H 01 B 5/16, H 01 B 1/22,**
**H 01 R 4/04, C 09 J 7/00**

(30) Priority: **18.10.86 JP 248095/86**
**03.02.87 JP 23227/87**

(43) Date of publication of application:
**27.04.88 Bulletin 88/17**

(84) Designated Contracting States: **CH DE FR GB LI**

(71) Applicant: **JAPAN SYNTHETIC RUBBER CO., LTD.**
**11-24, Tsukiji-2-chome Chuo-ku**
**Tokyo 104 (JP)**

(72) Inventor: **Kasai, Kiyoshi**
**1-14 Mizuhodai**
**Kameyama-shi (JP)**

Watanabe, Masaji
10-14 Shinoharahigashi-3-chome
Kohoku-ku Yokohama (JP)

Hattori, Masayuki
98-22 Aza Nishimaeshinden Oaza Uguiura
Yatomicho Ama-gun Aichi-ken (JP)

Tadenuma, Hiroshi
Nihon Gosei Gomu Shataku 4-101 1 Morigayamacho
Yokkaichi-shi (JP)

Miyamoto, Masahiro
Nihon Gosei Gomu Shofuryo 1 Morigayamacho
Yokkaichi-shi (JP)

(74) Representative: **Clifford, Frederick Alan et al**
**MARKS & CLERK 57/60 Lincoln's Inn Fields**
**London WC2A 3LS (GB)**

(54) **Electroconductive particles and electroconductive adhesive containing said particles.**

(57) Electroconductive particles having substantially uniform particle diameters, which are obtained by forming a thin metal layer on the surface of each of fine polymer particles having such a narrow particle diameter distribution that at least 80% by weight of the polymer particles have particle diameters falling within a range of 0.9Sn to 1.1Sn wherein Sn is defined as the number average particle diameter of the polymer particles, as well as an electroconductive adhesive consisting essentially of (a) said electroconductive particles and (b) an electrically insulating adhesive material. Use of this electroconductive adhesive makes it possible to obtain good, anisotropic, electric connection.

FIG. I

EP 0 265 212 A1

**Description**

ELECTROCONDUCTIVE PARTICLES AND ELECTROCONDUCTIVE ADHESIVE CONTAINING SAID
PARTICLES

This invention relates to electroconductive particles and an electroconductive adhesive containing said particles. More particularly, this invention relates to an electroconductive adhesive which is suited for use in connection of electric circuits, for example, connection of electronic components (e.g. integrated circuits) to a printed circuit board.

In recent years, making electric equipment and apparatus lighter, thinner, smaller and more functional is becoming increasingly important. To respond to these requirements, a surface mount technology (hereinafter referred to as SMT) is being introduced for mounting electronic components such as integrated circuits and the like on a printed circuit board and connecting the components to the printed circuit board. This SMT brings about various advantages such as miniaturization of electronic equipment and apparatus, making the density higher, automation of fabrication, enhancement of reliability and reduction of cost. However, the problem to be still solved is connection with higher reliability of much more miniaturized electronic components to a printed circuit board.

The so-called molten metal connecting method such as reflow-soldering method, wire-bonding method, solder paste method or the like is currently adopted for mounting and connecting electronic components on a printed circuit board. In this connecting method requiring melting a metal, the spreading of the molten metal results in a limit in connectable electrode pitch. Generally, the approximate limit of electrode pitch is said to be 2.5 to 3 electrodes per mm. A flip chip method is proposed as a rational method for high density integration; however, this method also has a limit in very fine connection and accordingly a limit in high density integration.

As other representative techniques for fine connection, there are methods in which metal particles as an electroconductive material, such as the method disclosed in Japanese Patent Application (Laid-Open) No. 218,706/85 which uses an electroconductive adhesive film containing nickel particles and the method disclosed in Japanese Patent Application Kokai (Laid-Open) No. 170, 176/80 which uses an electroconductive adhesive containing solder particles. In the above electroconductive adhesive film or adhesive, however, use of metal particles having a broad particle diameter distribution is inevitable because the production of fine metal particles having substantially uniform particle diameters is difficult under the current technique for controlling the particle diameters of metal particles. This matter has made it impossible to achieve highly reliable fine connection of at least 3 electrodes per mm, because in such fine connection no contact point is formed or even if formed, the contact is through a coarse particle or a lump of a plurality of fine particles contacting with one another.

As described above, with (1) the molten metal connecting method and (2) the method in which an electroconductive adhesive film or adhesive containing metal particles as an electroconductive material is used, each of the methods being a representative connecting method, it is impossible to achieve, with a high reliability, connection of electronic components excellent in the so-called anisotropic electroconductivity that the electroconductivity is high in the thickness direction and the electric insulation is high in the transverse direction. Particularly, fine connection at an electrode pitch of at least 3 electrodes per mm in the SMT has been impossible by the above known methods.

Based on the fact that fine connection can be greatly improved if electroconductive particles having a very narrow particle diameter distribution, namely substantially uniform particle diameters are obtained, the inventors of this invention have made extensive research. As a result, it has been found that the above problem can be solved by using, as the electroconductive material, electroconductive particles having substantially uniform particle diameters which are obtained by forming a thin metal layer on the surface of each of fine polymer particles having a very narrow particle diameter distribution produced according to the process previously proposed by the same inventors.

An object of this invention is to provide electro conductive particles by which the above mentioned problems have been solved, and which have an excellent anisotropic electroconductivity and enables fine connection of electronic components with a high reliability, particularly at an electrode pitch of at least 3 electrodes per mm.

Another object of this invention is to provide an electroconductive adhesive containing said electroconductive particles.

Other objects and advantages of this invention will become apparent from the following description.

According to this invention, there is provided electroconductive particles having substantially uniform particle diameters, which are obtained by forming a thin metal layer on the surface of each of fine polymer particles having such a narrow particle diameter distribution that at least 80% by weight of the polymer particles have particle diameters falling within a range of 0.9Sn to 1.1Sn wherein Sn is defined as the number average particle diameter of the polymer particles.

This invention further provides an electroconductive adhesive consisting of the above electroconductive particles and an electrically insulating adhesive material.

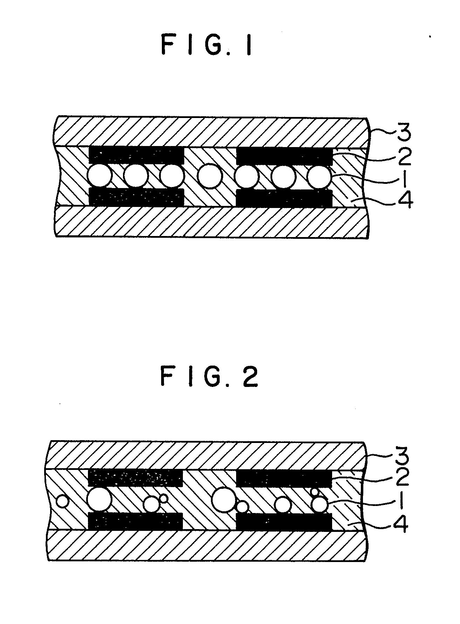

This invention will be explained in detail below referring to the accompanying drawings. In the drawings, Fig. 1 is a schematic view of a cross-section of electric circuits connected with the electroconductive adhesive of this invention containing electroconductive particles having uniform particle diameters, and Fig. 2 is a schematic view of a cross-section of electric circuits connected with an electroconductive adhesive for comparison containing electroconductive particles having non-uniform particle diameters. In Figs. 1 and 2, 1 is electroconductive particles, 2 is electroconductive portions of connection terminals, 3 is insulating portions of connection terminals, and 4 is an electrically insulating adhesive material.

The polymer particles used in this invention are fine polymer particles having such a very narrow particle diameter distribution that at least 80% by weight, preferably at least 85% by weight, of the polymer particles have particle diameters falling within a range of 0.9Sn to 1.1Sn wherein Sn is defined as the number average particle diameter of the polymer particles.

Fig. 1 shows a schematic view of a case where an electroconductive adhesive consisting of (a) electroconductive particles obtained by forming a thin metal layer on the surfaces of each of the above fine polymer particles having said narrow particle diameter distribution and (b) an electrically insulating adhesive material has been used between electric circuits for their connection so that the distance between the electric circuits after connection becomes approximately equal to the diameter of the electroconductive particles (a). As is clear from this schematic view, each of the electroconductive particles (a) having uniform particle diameters exists as a single particle between the electric circuits and the upper and lower ends of each particle contact accurately with the upper and lower electric circuits, respectively, whereby the conduction between the electric circuits is achieved with a high reliability.

In contrast, Fig. 2 shows a schematic view of a case where an electroconductive adhesive consisting of (a) electroconductive particles having non-uniform particle diameters obtained by forming a thin metal layer on the surfaces of each of polymer particles having a broader particle diameter distribution outside the above range and (b) an electrically insulating adhesive material has been used between electric circuits in the same manner as above. As is clear from Fig. 2, those electroconductive particles having smaller particle diameters exist between the electric circuits without contacting with the circuits and only a limited number of electroconductive particles having larger particle diameters or lumps each consisting of a plurality of electroconductive particles having small particle diameters but contacting with one another contribute to the connection of the electric circuits. Consequently, the reliability of conduction between the electric circuits is very low. Incidentally, when the previously mentioned known electroconductive adhesive film or adhesive, which contains, as an electroconductive material, metal particles having non-uniform particle diameters, namely a broad particle diameter distribution is used, the metal particles exist in a state similar to that of the electroconductive particles in Fig. 2.

For the reasons mentioned above, the polymer particles used in this invention must have such a particle diameter distribution that at least 80% by weight of the polymer particles have particle diameters falling within a range of 0.9Sn to 1.1Sn wherein Sn is defined as the number average particle diameter of the polymer particles. The number average particle diameter Sn of the polymer particles is preferably about 1 to 50 μm. As is clear from the foregoing explanation, both the polymer particles and the electroconductive particles obtained by forming a thin metal layer on the surface of each of the polymer particles used in this invention are preferably spherical in order to assure fine connection with a high reliability.

The number average particle diameter in this invention is determined by taking a photograph of electroconductive particles with a scanning type electron microscope according to an ordinary method, measuring on the micrograph the diameters of 100 particles chosen at random, and calculating the number average of the diameters.

The polymer particles having a narrow particle diameter distribution used in the production of the electroconductive particles having uniform particle diameters of this invention can be produced by any method as long as the produced polymer particles satisfy the above requirements. In particular, the production processes previously proposed by the present inventors [see Japanese Patent Application Kokai (Laid-Open) Nos. 215,602/86, 215,603/86 and 215,604/86] are preferable because the processes produce fine particles having a nearly spherical form. A representative process for producing the same will be described below.

To an aqueous dispersion of seed particles having uniform particle diameters prepared according to, e.g., soap-free polymerization is added a highly oleophilic substance having a solubility in water of 0.02% by weight or less, preferably 0.02 to 0.001% by weight and a molecular weight of 5,000 or less, preferably 500 or less, and the seed particles are allowed to absorb the highly oleophilic substance to increase the monomer absorption ability of the seed particles. Then, a monomer is added thereto and the seed particles are allowed to swell to a volume of at least about 100 to 10,000 times the original volume. Subsequently, polymerization is effected to obtain the desired polymer particles having a narrow particle diameter distribution.

Any monomer may be used above as long as it is radically polymerizable. It includes aromatic alkenyl monomers such as styrene, alpha-methylstyrene, vinyltoluene, 4-vinylpyridine, divinylbenzene and the like; alkyl esters of ethylenically unsaturated carboxylic acids such as butyl acrylate, butyl methacrylate, methyl methacrylate, 2-ethylhexyl acrylate, N-dimethylaminoethyl methacrylate and the like; unsaturated nitriles such as acrylonitrile, methacrylonitrile and the like; alkenyl chlorides such as vinyl chloride, vinylidene chloride and the like; and vinyl esters such as vinyl acetate, vinyl propionate and the like. These monomers can be used alone or in combination of two or more. When a polyfunctional vinyl monomer such as divinylbenzene, trimethylolpropane acrylate, polyethylene glycol diacrylate or the like is used in an amount of at least 2% by weight, preferably at least 5% by weight and more preferably 10% by weight, based on the weight of the total monomers, the resulting polymer particles and the electroconductive particles obtained by forming a thin metal layer on the surface of each of said polymer particles have a higher hardness and, as a result, reliable electric connection can be obtained. When a functional group-containing monomer such as acrylic acid, methacrylic acid, itaconic acid, styrenesulfonic acid, its salt, N,N-dimethylaminoethyl methacrylate, mono(acryloyloxyethyl)acid phosphite or the like is copolymerized with the above monomers, the resulting polymer particles have an increased bonding strength to plated metal.

As the seed particles, those capable of absorbing the monomer to be swollen are preferred. Specific examples thereof include styrene polymers, styrene copolymers (e.g., a styrene-butadiene copolymer and the like), acrylic ester polymers and vinyl acetate polymers. The seed particles can be of a homopolymer or a copolymer and the starting monomers for the seed particles may be different from the monomers to be polymerized.

Specific examples of the highly oleophilic substance include hexane, heptane, octane, 1-chlorododecane, dioctyl adipate, stearyl methacrylate and the like. Also, there may be used lauroyl peroxide, benzoyl peroxide, 3,5,5-trimethylhexanoyl peroxide, and the like, all of which have a function as polymerization initiator.

More specifically explaining, a fine aqueous dispersion of a highly oleophilic substance is first added to an aqueous dispersion of seed particles and the resulting mixture is slowly stirred usually for at least one hour until the droplets of the highly oleophilic substance are completely absorbed by the seed particles. Then, an aqueous dispersion of a monomer is added thereto and the mixture is slowly stirred usually for at least one hour until the droplets of the monomer are completely absorbed into the seed particles. In this absorption procedure, it is possible to add a water-soluble organic solvent or a water-soluble salt in order to accelerate the absorption of the finely dispersed droplets into the seed particles. However, care must be taken for this addition, because in some cases the seed particles are instabilized and aggregated, whereby the polymer particles produced have a broad particle diameter distribution.

After the finely dispersed droplets have disappeared and have completely been absorbed into the seed particles, the temperature of the system is elevated and polymerization is effected. The polymerization initiator used is preferably oil-soluble, and azobisisobutyronitrile, t-butylperoxy-2-ethyl hexaonate, benzoyl peroxide, etc. can be used. It is advisable that the polymerization initiator be used after dissolving it in the monomer. A peroxide, which has a polymerization initiation ability, is preferably used as the above oleophilic substance to act as a polymerization initiator, too. The polymerization temperature is usually 40° to 90°C, preferably 50° to 80°C.

In the above polymerization, it is necessary to use a dispersion stabilizer in order to increase the stability of the dispersed polymer particles produced. As such a dispersion stabilizer, there can be used those usually employed for general stabilization of dispersion, and anionic or nonionic surfactants and organic or inorganic suspension-protecting agents are used. As a preferable dispersion stabilizer, a polyvinyl alcohol having a saponification degree of 95 to 55% and a polymerization degree of 500 to 3,000 can be used.

In some cases, in the polymerization polymer particles are formed in the aqueous phase independently of the seed particles, depending upon the monomer combination used. To avoid this, it is possible to add a water-soluble polymerization inhibitor such as ferric chloride, sodium sulfite, hydroquinone, potassium bichromate, copper sulfate or the like.

The electroconductive particles used in this invention can be produced by forming a thin metal layer on the surface of each of the polymer particles produced as above. The formation of the thin metal layer can be conducted according to any desired method, typically, a metal plating method. There can be used, for example, a wet electroless plating method, an electroplating method, a surface-metallizing method wherein a metal carbonyl compound is subjected to pyrolysis in a gas phase, a method of vapor-depositing a metal in vacuum and a plating method by ion spattering. There can also be used a film formation method wherein polymer particles having fine metal particles thereon are collided with one another in a gas stream to embed the metal particles onto the surfaces of the polymer particles.

The kind of the metal to be applied as a thin layer on the surface of each of the polymer particles is not critical as long as the polymer particles after formation of a thin metal layer thereon have electroconductivity. It includes, for example, nickel, tin, copper, silver, gold, palladium and lead. Particularly, gold and palladium are effective for obtaining good and stable connection over a long period of time. The thin metal layer can be formed not only as a single layer but also as a double layer. For example, a double layer consisting of an inner layer of nickel and an outer layer of gold can be formed.

The conditions for plating are not critical as long as a uniform thin metal layer of a desired thickness can be formed on the surface of each of the polymer particles.

The thickness of the thin metal layer formed on the polymer particles is not critical as long as sufficient connection of electric circuits can be achieved but it is usually about 0.01 to 2 $\mu$m.

The electroconductive particles produced as above have a number average particle diameter of preferably 2 to 30 $\mu$m, more preferably 5 to 20 $\mu$m. When the number average particle diameter exceeds 30 $\mu$m, the number of contact points per unit area of fine electrode decreases and moreover crosstalk between adjacent electrodes tends to occur and, as a result, reliable fine connection cannot be obtained. When the number average particle diameter is less than 2 $\mu$m, thickness variation as well as surface roughness of the connected electrode and printed circuit board affect much the number of actual contact points. Therefore, reliable fine connection cannot be achieved. Use of electroconductive particles having a number average particle diameter falling within the above range of 2 to 30 $\mu$m can achieve fine multi-point electrode connection at an electrode pitch of at least 3 electrodes per mm.

In the use of the electroconductive particles of this invention for connecting electric circuits, it is advisable

4

to mix the electroconductive particles with an electrically insulating adhesive material selected from thermoplastic resins, thermosetting resins and materials for radiation-curable resins in order to make the connection reliable. This adhesive material is required to have an excellent adhesive property and an excellent insulating property, because it constitutes an adhesive having an anisotropic electroconductivity for connecting electric circuits together with the electroconductive particles and the adhesive must electrically connect only those terminals needing connection, while electrically insulating the adjacent terminals.

The thermoplastic resins usable as the electrically insulating adhesive material include an ethylene-vinyl acetate copolymer; a polyethylene; an ethylene-propylene copolymer; an ethylene-acrylic acid ester copolymer; an ethylene-acrylic acid salt copolymer; a polyisobutylene; an atactic polypropylene; a polyvinyl ether; a polyvinyl butyral; ethyl cellulose; a polyester; a polyamide; a polyurethane; natural rubber; and synthetic rubbers such as an acrylic acid ester rubber, an acrylonitrile-butadiene copolymer, a styrene-isobutylene block copolymer, a polybutadiene, a silicone rubber, a polychloroprene and the like.

The thermosetting resins include an epoxy resin, an acrylic acid ester resin, a melamine resin, a phenolic resin, etc. Of these, the epoxy resin and the acrylic acid ester resin can be used preferably.

These thermoplastic resins and thermosetting resins can be used alone or in combination of two or more. If necessary, they can be dissolved in a solvent for use as a solution. A crosslinking agent, an antioxidant, a tackifier, etc. can be added to the resins, if necessary.

The materials for radiation-curable resins include photopolymerizable monomers which can be cured upon irradiation with a radiation such as ultraviolet rays, electron beam, X-rays, visible light or the like, for example, an acrylic acid ester of a polyhydric alcohol, urethane acrylate, an unsaturated ester of a polycarboxylic acid, an unsaturated amide, an acetylenically unsaturated group-containing monomer, a glycidyl group-containing monomer and the like. These monomers can be used alone or in combination of two or more. Prepolymers or polymers such as an epoxy acrylate, a polyester acrylate, a polyurethane acrylate, a polyvinyl alcohol acrylate, a polyamide acrylate, a polycarboxylic acid acrylate and the like can also be used alone or in combination of two or more as the material for radiation-curable resins. A sensitizer such as benzophenone, a Michler's ketone or the like and, if necessary, additives such as a solvent, a dye, a pigment, a plasticizer and the like can be added to the material for radiation-curable resins. A heat crosslinking-curing agent, an antioxidant, etc. can also be added, if necessary.

Of the electrically insulating adhesive materials mentioned above, the thermosetting resin and the material for radiation-curable resin are used preferably.

The amount of the electroconductive particles in the electroconductive adhesive is 0.1 to 20% by volume, preferably 1 to 15% by volume, more preferably 2 to 10% by volume. When the amount exceeds 20% by volume, the electroconductive adhesive shows poor electric insulation in the direction to adjacent electric circuits and is unable to provide a sufficient anisotropic electro conductivity. When the amount is less than 0.1% by volume, the electroconductive adhesive shows incomplete conduction between electric circuits.

It is preferable that the electroconductive particles of this invention are uniformly dispersed in the electrically insulating adhesive material in order to obtain sufficiently reliable conduction.

The electroconductive particles of this invention are mixed with the electrically insulating adhesive material; the resulting mixture is coated on the whole surfaces of the predetermined portions of electric circuits to be connected; the coated electric circuit portions are registered with one another; and then the adhesive material is subjected to heat-bonding under pressure or radiation-curing, whereby the electric circuits are connected. Post-baking can be conducted if necessary to make the connection more reliable.

In this invention, the thickness of the electroconductive adhesive coated is preferably about 1 to 3 times the number average particle diameter of the electroconductive particles in order to obtain fine connection. When the thickness is smaller than the number average particle diameter of the electroconductive particles, namely, less than 1 time, the number of the electroconductive particles present on each fine electrode is remarkably small and highly reliable connection becomes difficult to obtain. On the other hand, when the thickness exceeds 3 times the number average particle diameter of the electroconductive particles, the proportion of the electroconductive particles flowing into the non-conductive groove portions between electrodes during the heat-bonding under pressure with the adhesive is large; and crosstalk tends to be caused between the adjacent electrodes when the electrode pitch is at least 3 electrodes per mm. As a result, it is difficult to obtain reliable connection.

The use of the electroconductive adhesive of this invention consisting of electroconductive particles having substantially uniform particle diameters and an electrically insulating adhesive material enables good anisotropic electric connection to be obtained, and accordingly, highly reliable conduction can be achieved between electric circuits. Therefore, the electroconductive adhesive of this invention is very useful for connection of electric circuits which are becoming denser and finer in recent years and particularly useful for surface-mounting electronic components.

This invention will be explained in more detail referring to Examples, which are by way of illustration and not by way of limitation.

EXAMPLES 1 TO 5

## PRODUCTION OF POLYMER PARTICLES

2 parts by weight of dioctanoyl peroxide which is a highly oleophilic substance and also acts as a polymerization initiator, 0.15 part by weight of sodium laurylsulfate and 20 parts by weight of water were subjected to a high-pressure piston pump type homogenizer (Type 15 M manufactured by Manton Gaulin Co.). to finely disperse droplets having a diameter of 0.15 μm or less.

The thus obtained fine dispersion of the highly oleophilic substance was added to a mixture consisting of
(a) 1.1 parts by weight of an aqueous dispersion of polystyrene particles obtained by a conventional soap-free polymerization and having a number average particle diameter of 0.75 μm and a variation coefficient of 4% (the dispersion had a solids content of 10.0% by weight and accordingly contained 0.11 part by weight of solids),
(b) 10 parts by weight of water and (c) 6 parts by weight of acetone, and the resulting mixture was slowly stirred at 20°C for 48 hours, to allow the highly oleophilic substance to be deposited on the polystyrene particles as seed particles and to be absorbed thereinto.

Thereto were added 100 parts by weight of an aqueous solution containing 10% by weight of a polyvinyl alcohol, 400 parts by weight of water, and then a monomer component having the composition shown in Table 1. The resulting mixture was slowly stirred at 30°C for 2 hours, whereby the monomer component was absorbed into the seed particles. Then, the system temperature was elevated to 75°C and polymerization was effected at this temperature for 12 hours to produce polymer particles having a number average particle diameter and a particle diameter distribution, both as shown in Table 1.

## THIN METAL LAYER

A thin metal layer was formed on the surface of each of the polymer particles produced above, according to the following electroless plating method.

In 30 g of a 1% aqueous solution of sodium laurylsulfate were uniformly dispersed 10 g of the polymer particles. Thereto was added 100 ml of a 3 N mixed acid of potassium bichromate and sulfuric acid. The resulting mixture was treated at 90°C for 90 minutes to chemically etch the surfaces of the polymer particles. Then, the polymer particles were filtered, water-washed, neutralized with 1 N hydrochloric acid, filtered and water-washed. The resulting polymer particles were immersed in 200 ml of an aqueous solution containing 0.5% by weight of palladium chloride for 10 minutes, then filtered and water-washed, to activate the surfaces of the polymer particles. The thus surface-activated polymer particles were placed in 200 ml of 5 N hydrochloric acid. Then, the polymer particles were placed in an aqueous solution of a sulfate of a plating metal, namely nickel sulfate or copper sulfate, and subjected to electroless plating for 12 hours, to obtain electroconductive particles.

In Example 5, gold plating in an aqueous potassium dicyanoaurate was conducted after the nickel plating with nickel sulfate, to form a thin metal layer having a double layer structure.

## ELECTROCONDUCTIVE ADHESIVE

In 1,000 parts by weight of toluene were dissolved 100 parts by weight of a styrene-vinyl acetate copolymer having a vinyl acetate content of 6% by weight and a melt index of 2.5 and 100 parts by weight of a rosin type tackifier having a softening point of 70°C. Thereto were added 30 parts by weight of the electroconductive particles obtained above. The resulting mixture was thoroughly stirred to prepare an electroconductive adhesive. This adhesive was coated on a release paper using a coater and then dried at 100°C for 10 minutes to prepare an electroconductive adhesive having a thickness of 10 to 15 μm.

## EVALUATION

(a) Through-layer-resistivity

Each of the electroconductive adhesives prepared above was placed between two aluminum plates each having a thickness of 1 mm and pressed at 140°C to a thickness of 95 to 110% of the particle diameters of the electroconductive particles contained in the electroconductive adhesive. Then, the electric resistivity between the two aluminum plates was measured.

(b) Along-layer-resistivity

Each of the electroconductive adhesives was bonded to a polyester film, and the electric resistivity of the resulting adhesive film in the longitudinal direction was measured.

(c) Fine-portion-conductivity

Each of the electroconductive adhesives was tested for fine-portion-conductivity using 10 sets of two same terminals having different electrode pitches of 1 to 10 electrodes per mm, in each of which sets the terminal consisted of 100 electrode portions and 100 insulating portions arranged alternately at a constant interval (each electrode portion and each insulating portion had the same length), in the following manner:

Each of the electroconductive adhesives was placed between the two same terminals of each of the above 10 sets and compressed to a thickness of 95 to 110% of the particle diameters of the electroconductive particles, after which the conduction between electrode portions of the two terminals was measured to determine a minimum electrode pitch (a maximum number of electrodes per mm) under the conditions that

**0 265 212**

any facing electrode portions had good conduction (i.e., through-layer-resistivity: 1 $\Omega \bullet$cm or less) and conduction to any adjacent electrode portions was nothing (i.e., resistivity: $10^5$ $\Omega \bullet$c or more). The minimum electrode pitch was taken as the fine-portion-conductivity of the electroconductive adhesive.

(d) Connection reliability

The two terminals connected with each other in (c) above were placed as such in a thermo-hygrostat and allowed to stand for 1,000 hours at 85°C at a relative humidity of 85%. Then, the fine-portion-conductivity was determined and taken as the connection reliability of the electroconductive adhesive.

(e) Apparent volume resistivity

The electroconductive particles prepared above were placed between two same electrodes each having a surface area of 10 cm$^2$. While applying a pressure of 1 kg/cm$^2$ to them, a DC voltage of 10 to 100 V was applied and the resistivity was measured.

The results are shown in Table 1.

COMPARATIVE EXAMPLE 1

An electroconductive adhesive was prepared in the same manner as in Example 1, except that the electroconductive particles used in Example 1 were replaced by solder particles composed of tin and lead (62/38 by weight) and having a melting point of 183°C (the solder particles had a number average particle diameter of 8.0 $\mu$m and contained particles having particle diameters of 7.2 to 8.8 $\mu$m in an amount of 50% by weight). The adhesive was evaluated in the same manner as in Example 1.

The results are shown in Table 1.

COMPARATIVE EXAMPLES 2 TO 4

Electroconductive adhesives were prepared in the same manner as in Comparative Example 1, except that the volume fraction of the solder particles in the adhesive was varied. Each adhesive was evaluated in the same manner as in Example 1.

The results are shown in Table 1.

7

Table 1

| | Ex.1 | Ex.2 | Ex.3 | Ex.4 | Ex.5 | Comp. Ex.1 | Comp. Ex.2 | Comp. Ex.3 | Comp. Ex.4 |
|---|---|---|---|---|---|---|---|---|---|
| Polymer particles | | | | | | | | | |
| Monomer proportions ST | 100 | 65 | — | 65 | 65 | — | — | — | — |
| MMA | — | — | 50 | — | — | — | — | — | — |
| DVB | — | 30 | 50 | 30 | 30 | — | — | — | — |
| MA | — | 5 | — | — | — | — | — | — | — |
| NASS | — | — | — | 5 | 5 | — | — | — | — |
| Number average particle diameter Sn (μm) | 7.2 | 7.1 | 7.2 | 7.1 | 7.1 | — | — | — | — |
| Proportion of particles having particle diameters of 0.9Sn to 1.1Sn (wt. %) | 95 | 94 | 95 | 93 | 95 | — | — | — | — |
| Electroconductive particles | | | | | | | | | |
| Plating metal | Ni | Ni | Cu | Cu | Ni/Au | — | — | — | — |
| Plating thickness (μm) | 0.5 | 1.0 | 0.3 | 0.5 | 0.5/0.1 | — | — | — | — |
| Number average particle diameter S (μm) | 8.2 | 9.1 | 7.8 | 8.1 | 8.3 | 8.0 | 8.0 | 8.0 | 8.0 |

Table 1 (Cont'd)

| | | | | | | | | |
|---|---|---|---|---|---|---|---|---|
| Proportion of particles having particle diameters of 0.9S to 1.1S (wt. %) | 94 | 92 | 92 | 91 | 92 | 50 | 50 | 50 | 50 |
| Apparent volume resistivity ($\Omega \cdot cm$) | $2 \times 10^{-2}$ | $2 \times 10^{-2}$ | $1 \times 10^{-2}$ | $2 \times 10^{-2}$ | $5 \times 10^{-3}$ | $2 \times 10^{-2}$ | $2 \times 10^{-2}$ | $2 \times 10^{-2}$ | $2 \times 10^{-2}$ |
| Specific gravity of particles | 1.93 | 2.91 | 1.42 | 1.96 | 1.99 | – | – | – | – |
| Volume fraction of electroconductive particles in adhesive (%) | 7.2 | 4.2 | 9.5 | 7.1 | 7.0 | 4.0 | 7.0 | 15.0 | 35 |
| Evaluation results | | | | | | | | | |
| Through-layer-resistivity ($\Omega \cdot cm$) | $5 \times 10^{-2}$ | $5 \times 10^{-2}$ | $5 \times 10^{-2}$ | $5 \times 10^{-1}$ | $1 \times 10^{-3}$ | $1 \times 10^{8}$ | $2 \times 10^{5}$ | $5 \times 10^{3}$ | $1 \times 10^{-2}$ |
| Along-layer-resistivity ($\Omega \cdot cm$) | $5 \times 10^{9}$ | $2 \times 10^{8}$ | $2 \times 10^{9}$ | $1 \times 10^{9}$ | $5 \times 10^{10}$ | $5 \times 10^{10}$ | $2 \times 10^{9}$ | $3 \times 10^{9}$ | $2 \times 10^{3}$ |
| Fine-portion-conductivity (number of electrodes/mm) | 10 | 8 | 8 | 6 | 10 | 3 | 3 | 2 | 1 |
| Connection reliability (number of electrodes/mm) | 8 | 6 | 5 | 5 | 10 | 2 | 2 | 1 | 1 |

Notes: ST: Styrene, MMA: Methyl methacrylate, DVB: Divinylbenzene, MA: Methacrylic acid, NASS: Sodium Styrenesulfonate

As is clear from Table 1, with electroconductive adhesives containing electroconductive particles having non-uniform particle diameters, the difference between through-layer-resistivity and along-layer-resistivity cannot be made large and cannot be maintained stably even if the volume fraction of the electroconductive particles in the adhesive is varied greatly (see Comparative Examples 1 to 4). On the other hand, when electroconductive adhesives containing electroconductive particles having uniform particle diameters are used at a thickness approximately equal to the particle diameters of the electroconductive particles, the difference between through-layer-resistivity and along-layer-resistivity can be made large and can be maintained stably. In these electroconductive adhesives, connection reliability was high and connection at an electrode pitch of at least 5 electrodes per mm was possible (see Examples 1 to 5).

EXAMPLE 6

The nickel-plated polymer particles having uniform particle diameters obtained in Example 2 were mixed with an epoxy type adhesive [Araldite (main agent) of Ciba-Geigy Corp.] so that the volume fraction of the polymer particles in the mixture became 8% by weight. This mixture was mixed with an amine type curing agent [Araldite (curing agent) of Ciba-Geigy Corp.] to prepare a liquid adhesive in which the volume fraction of the electroconductive polymer particles was 6% by weight.

This adhesive was placed between two same aluminum plates each having a thickness of 1 mm and pressed at a pressure of 5 kg/cm$^2$ at ordinary temperature to form an adhesive layer having a thickness of 9.0 μm which was approximately the same as the number average particle diameter of the electroconductive particles. The adhesive was allowed to stand under the above pressure and temperature conditions for 10 hours to complete curing. The resulting laminate was measured for through-layer-resistivity in the same manner as in Example 1. The through-layer-resistivity was $2 \times 10^{-2}$ Ω•cm.

The above adhesive was sandwiched between a polyester film and a release paper and then cured in the same manner as above. The resulting laminate was measured for along-layer-resistivity in the same manner as in Example 1. The along-layer-resistivity was $5 \times 10^9$ Ω•cm.

The adhesive was also measured for fine-portion-conductivity and connection reliability in the same manner as in Example 1. The fine-portion-conductivity was 10/mm and the connection reliability was 8/mm.

EXAMPLES 7 TO 11

POLYMER PARTICLES

Polymer particles were produced in the same manner as in Examples 1 to 5, except that the monomer component shown in Table 2 was used.

THIN METAL LAYER

A thin metal layer was formed on the surface of each of the polymer particles produced above, in the same manner as in Examples 1 to 5.

ELECTROCONDUCTIVE ADHESIVE

In Examples 7, 8 and 9, 100 parts by weight of an epoxy resin (Phenototo YP-50 manufactured by Toto Kasei K.K.) was dissolved in 200 parts by weight of methyl ethyl ketone. Thereto were added the metal-plated electroconductive particles prepared above, in a volume fraction as shown in Table 2. The resulting mixture was thoroughly stirred to prepare an electroconductive adhesive.

In Examples 10 and 11, the metal plated electroconductive particles were added to an UV-curing resin [DPR-105 (an epoxy acrylate resin) manufactured by Asahi Kaken K.K.] in a volume fraction as shown in Table 2. The mixture was thoroughly stirred to prepare an electroconductive adhesive.

EVALUATION

(a) Through-layer-resistivity

Each of the electroconductive adhesives of Examples 7, 8 and 9 was placed between two aluminum plates each having a thickness of 1 mm and pressed at 140°C to a thickness of 95 to 110% of the particle diameters of the electroconductive particles contained in the electroconductive adhesive. Then, the electric resistivity between the two aluminum plates was measured.

(b) Along-layer-resistivity

Each of the electroconductive adhesives was coated on a polyester film and pressed at 140°C to form an adhesive layer of 10 μm in thickness, and its electric resistivity in the transverse direction was measured.

In Examples 10 and 11, however, irradiation with ultraviolet rays through the polyester film was adopted in place of the heat-pressing adopted in Examples 7, 8 and 9, to cure each electroconductive adhesive, whereby an adhesive layer of 10 μm in thickness was formed.

(c) Fine-portion-conductivity

Each of the electroconductive adhesives was placed in a thickness as shown in Table 2 between two same terminals in the same manner as in Examples 1 to 5, and the electroconductive adhesive was heat-pressed to a thickness of 95 to 110% of the particle diameters of the electroconductive particles contained in the electroconductive adhesive, or UV-cured to the same thickness. Then, the conduction between electrode portions of the two terminals was measured to determine a minimum electrode pitch (a maximum number of electrodes per mm) under the conditions that any facing electrode portions have good conduction (i.e., through-layer-resistivity: 1 $\Omega \bullet$cm or less) and conduction to any adjacent electrode portions was nothing (i.e., resistivity: $10^5$ $\Omega \bullet$cm or more). The minimum electrode pitch was taken as the fine-portion-conductivity of the electroconductive adhesive.

(d) Connection reliability

The two terminals connected with each other in (c) above were placed as such in a thermo-hygrostat and allowed to stand for 1,000 hours at 85°C at a relative humidity of 85%. Then, the fine portion conductivity was determined and taken as the connection reliability of the electroconductive adhesive.

(e) Apparent volume resistivity

The electroconductive particles prepared above were placed between two electrodes each having a surface area of 10 cm². While applying a pressure of 1 kg/cm² to them, a DC voltage of 10 to 100 V was applied and the resistivity was measured.

The results are shown in Table 2.

COMPARATIVE EXAMPLE 5

An electroconductive adhesive was prepared in the same manner as in Example 7, except that the electroconductive particles used in Example 7 were replaced by solder particles composed of tin and lead (62/38 by weight) and having a melting point of 183°C (the solder particles had a number average particle diameter of 10 μm and contained particles having particle diameters of 9 to 11 μm in a proportion of 70% by weight). The adhesive was evaluated in the same manner as in Example 7. The results are shown in Table 2.

COMPARATIVE EXAMPLES 6 AND 7

Electroconductive adhesives were prepared in the same manner as in Comparative Example 5, except that the volume fraction of the solder particles was varied. The adhesives were evaluated in the same manner as in Example 7. The results are shown in Table 2.

Table 2

| | Ex.7 | Ex.8 | Ex.9 | Ex.10 | Ex.11 | Comp. Ex.5 | Comp. Ex.6 | Comp. Ex.7 |
|---|---|---|---|---|---|---|---|---|
| **Polymer particles** | | | | | | | | |
| Monomer proportions ST | 90 | 90 | 90 | 85 | – | – | – | – |
| MMA | – | – | – | – | 50 | – | – | – |
| DVB | 10 | 10 | 10 | 5 | – | – | – | – |
| MA | – | – | – | 10 | 10 | – | – | – |
| Number average particle diameter Sn (µm) | 10 | 15 | 5 | 10 | 10 | – | – | – |
| Proportion of particles having particle diameters of 0.9Sn to 1.1Sn (wt. %) | 95 | 95 | 97 | 95 | 95 | – | – | – |
| **Electroconductive particles** | | | | | | | | |
| Plating metal | Ni | Cu | Ni/Au | Ni | Ni | – | – | – |
| Plating thickness (µm) | 0.3 | 0.3 | 0.3/0.1 | 0.3 | 0.3 | – | – | – |
| Number average particle diameter S (µm) | 10.6 | 10.6 | 10.8 | 10.6 | 10.6 | 10.3 | 10.3 | 10.3 |
| Proportion of particles having particle diameters of 0.9S to 1.1S (wt. %) | 95 | 95 | 97 | 95 | 95 | 70 | 70 | 70 |
| Apparent volume resistivity ($\Omega \cdot$ cm) | $2 \times 10^{-2}$ | $2 \times 10^{-2}$ | $5 \times 10^{-3}$ | $2 \times 10^{-2}$ | $2 \times 10^{-2}$ | $1 \times 10^{-2}$ | $1 \times 10^{-2}$ | $1 \times 10^{-2}$ |

– Cont'd –

Table 2 (cont'd)

| | | | | | | | | |
|---|---|---|---|---|---|---|---|---|
| Volume fraction of electroconductive particles in adhesive (%) | 5 | 10 | 5 | 3 | 0.5 | 5 | 0.5 | 10 |
| Adhesive material | *1 | *1 | *1 | *2 | *2 | *1 | *1 | *1 |
| Thickness of adhesive coated (dry·μm) | 15 | 30 | 10 | 10 | 10 | 15 | 15 | 15 |
| Evaluation results | | | | | | | | |
| Through-layer-resistivity (Ω·cm) | $5 \times 10^{-2}$ | $8 \times 10^{-2}$ | $5 \times 10^{-1}$ | – | – | $2 \times 10^{5}$ | $1 \times 10^{8}$ | $2 \times 10^{3}$ |
| Along-layer-resistivity (Ω·cm) | $5 \times 10^{10}$ | $7 \times 10^{10}$ | $5 \times 10^{10}$ | $5 \times 10^{10}$ | $5 \times 10^{10}$ | $5 \times 10^{9}$ | $5 \times 10^{10}$ | $3 \times 10^{9}$ |
| Fine-portion-conductivity (number of electrodes/mm) | 10 | 6 | 10 | 8 | 8 | 3 | 2 | 3 |
| Connection reliability (number of electrodes/mm) | 8 | 5 | 8 | 6 | 6 | 2 | 1 | 2 |

Notes: *1  Epoxy resin
       *2  Epoxy acrylate resin
Other symbols have the same meanings as in Table 1.

As is clear from Table 2, with electroconductive adhesives containing electroconductive particles having non-uniform particle diameters, the difference between through-layer-resistivity and along-layer-resistivity cannot be made large and cannot maintained stably even if the volume fraction of the electroconductive particles in the adhesive is varied greatly (see Comparative Examples 5 to 7). On the other hand, when electroconductive adhesives containing electroconductive particles having uniform particle diameters are used in a thickness approximately equal to the particle diameters of the electroconductive particles, the difference between through-layer-resistivity and along-layer-resistivity can be made large and can be maintained stably. In these electroconductive adhesives, connection reliability was high and connection at an electrode pitch of at least 5 electrodes per mm was possible (see Examples 7 to 11).

**Claims**

1. Electroconductive particles having substantially uniform particle diameters, which are obtained by forming a thin metal layer on the surface of each of fine polymer particles having such a narrow particle diameter distribution that at least 80% by weight of the polymer particles have particle diameters falling within a range of 0.9Sn to 1.1Sn wherein Sn is defined as the number average particle diameter of the polymer particles.

2. Electroconductive particles according to Claim 1, wherein the polymer particles are produced by allowing seed polymer particles to absorb a highly oleophilic substance, then adding at least one monomer thereto and subsequently polymerizing the monomer.

3. Electroconductive particles according to Claim 1, wherein the thin metal layer is formed by electroless plating.

4. Electroconductive particles according to Claim 1, wherein the number average particle diameter Sn of the polymer particles is 1 to 50 μm.

5. Electroconductive particles according to Claim 1, wherein the thin metal layer has a thickness of 0.01 to 2 μm.

6. An electroconductive adhesive consisting essentially of (a) electroconductive particles having substantially uniform particle diameters, which are obtained by forming a thin metal layer on the surface of each of fine polymer particles having such a narrow particle diameter distribution that at least 80% by weight of the polymer particles have particle diameters falling within a range of 0.9Sn to 1.1Sn wherein Sn is defined as the number average particle diameter of the polymer particles and (b) an electrically insulating adhesive material.

7. An electroconductive adhesive according to Claim 6, wherein the electroconductive particles (a) are fine, spherical particles having a number average particle diameter of 2 to 30 μm.

8. An electroconductive adhesive according to Claim 6 or 7, wherein the thin metal layer of each of the electroconductive particles (a) has a thickness of 0.01 to 2 μm.

9. An electroconductive adhesive according to Claim 6, 7 or 8, wherein the polymer particles constituting the electroconductive particles (a) are produced by allowing seed polymer particles to absorb a highly oleophilic substance, then adding at least one monomer thereto and subsequently polymerizing the monomer.

10. An electroconductive adhesive according to any one of Claims 6 to 9, wherein the thin metal layer of each of the electroconductive particles (a) is formed by electroless plating.

11. An electroconductive adhesive according to any one of Claims 6 to 10, wherein the electrically insulating adhesive material (b) is selected from thermoplastic resins, thermosetting resins and materials for radiation-curable resins.

12. An electroconductive adhesive according to any one of Claims 6 to 11, wherein the electroconductive particles (a) are used in an amount of 0.1 to 20% by volume based on the volume of the adhesive.

13. An electroconductive adhesive according to any one of Claims 6 to 12, wherein the electroconductive particles (a) are uniformly dispersed in the electrically insulating adhesive material (b).

0265212

# F I G. I

# F I G. 2

| | DOCUMENTS CONSIDERED TO BE RELEVANT | | EP 87309226.6 |
|---|---|---|---|

| Category | Citation of document with indication, where appropriate, of relevant passages | Relevant to claim | CLASSIFICATION OF THE APPLICATION (Int. Cl.4) |
|---|---|---|---|
| Y | GB - A - 2 170 365 (SHARP)<br>* Page 2, lines 5-83; fig. 4 *<br>-- | 1-13 | H 01 B 5/14<br>H 01 B 5/16<br>H 01 B 1/22<br>H 01 R 4/04 |
| Y | DE - A1 - 2 536 361 (SEIKOSHA)<br>* Page 4, line 3 - page 7, line 30; fig. 2,4,6 *<br>-- | 1,3,4, 6,7,10- 13 | C 09 J 7/00 |
| D,Y | JP - A2 - 61-215 602 (JAPAN SYNTHETIC)<br>* Claims; examples * | 2,9 | |
| P,Y | & Patent Abstracts of Japan, unexamined applications, C field, vol. 11 no. 53, February 19, 1987<br>The Patent Office Japanese Government<br>page 86 C 404<br>* JP-A-61-215 602 (JAPAN SYNTHETIC) *<br>-- | 2,9 | |
| Y | KIRK-OTHMER, Encyklopedia of Chemical Technology, 3rd edition, vol. 8, 1979<br>JOHN WILEG & SONS, "Plating of Plastics", New York (USA) pages 743-746<br>* Page 745, table 2, note a *<br>---- | 5,8 | TECHNICAL FIELDS SEARCHED (Int. Cl.4)<br>H 01 B<br>H 01 R    4/00<br>H 05 K<br>C 09 J<br>C 23 C 18/00<br>C 08 F   2/00 |

The present search report has been drawn up for all claims

| Place of search | Date of completion of the search | Examiner |
|---|---|---|
| VIENNA | 07-01-1988 | KUTZELNIGG |